# EUROPEAN PATENT APPLICATION

(11) **EP 4 401 291 A1**
(43) Date of publication of application: **17.07.2024**
(21) Application number: 22880302.9
(22) Date of filing: 11.10.2022
(51) Int. Cl.: H02M 1/00, H01R 25/16

(54) **POWER CONNECTION ASSEMBLY, INPUT UNIT, POWER CONVERTER AND COMMUNICATION POWER SUPPLY**

(30) Priority: 12.10.2021 CN 202111189062
(71) Applicant: Huawei Digital Power Technologies Co., Ltd., Shenzhen, Guangdong 518043 (CN)
(72) Inventor: MA, Cheng, Shenzhen, Guangdong 518043 (CN); GUO, Wei, Shenzhen, Guangdong 518043 (CN); YIN, Kai, Shenzhen, Guangdong 518043 (CN); DENG, Ziming, Shenzhen, Guangdong 518043 (CN)
(74) Representative: Isarpatent
(86) International application number: PCT/CN2022/124628
(87) International publication number: WO 2023/061365

(57) **Abstract**

This application provides a power connection assembly, an input unit, a power converter, and a communication power supply. The power connection assembly includes an input power distribution connector and a busbar group. The input power distribution connector has an input end and an output end. The input end of the input power distribution connector is configured to be plug-connected to an input module. The busbar group includes a plurality of busbars. Each busbar includes an input end and an output end. The input end of each busbar is connected to the output end of the input power distribution connector. Any two busbars form a busbar pair. The busbar pair supplies power to a power conversion module. The plurality of busbars included in the busbar group may be allocated to form a plurality of busbar pairs based on different power grid systems. Each busbar pair can supply power to one power conversion module. When a power supply voltage of a different system is connected, switching between power distribution systems may be performed by replacing only an input module that corresponds to the power supply voltage of the different system. This is simple and easy to implement. In this way, development and maintenance costs of devices are reduced.

## Description

### CROSS-REFERENCE TO RELATED APPLICATIONS

This application claims priority to Chinese Patent Application No. 202111189062.8, filed with the China National Intellectual Property Administration on October 12, 2021 and entitled "POWER CONNECTION ASSEMBLY, INPUT UNIT, POWER CONVERTER, AND COMMUNICATION POWER SUPPLY", which is incorporated herein by reference in its entirety.

### TECHNICAL FIELD

This application relates to the field of communication technologies, and in particular, to a power connection assembly, an input unit, a power converter, and a communication power supply.

### BACKGROUND

In the communication field, there are a plurality of power grid systems, for example, a single-phase alternating-current power grid, a three-phase alternating-current power grid, a dual-live wire alternating-current power grid, and a direct-current power grid. Generally, a communication device mainly includes an input module, a power conversion module, and a related output power distribution device. Currently, to enable the communication device to adapt to different power grid systems, power conversion apparatuses of different architectures need to be developed to match alternating-current/direct-current power grids of different systems. This greatly increases development and maintenance costs of devices.

However, when an existing communication device adapts to different power distribution systems, a structure layout is complex, and a user interface is not user-friendly. This causes poor customer use experience.

### SUMMARY

This application provides a power connection assembly, an input unit, a power converter, and a communication power supply, to facilitate compatibility with different power distribution systems.

According to a first aspect, this application provides a power connection assembly. The power connection assembly may be used in a power converter. The power connection assembly specifically includes an input power distribution connector and a busbar group. The input power distribution connector has an input end and an output end. The input end of the input power distribution connector is configured to be plug-connected to an input module, and the output end is configured to be connected to the busbar group. The busbar group specifically includes a plurality of busbars. Each busbar also has an input end and an output end. The input end of each busbar is configured to be connected to an output end of the power converter. In the busbar group, any two busbars may form a busbar pair. When in use, the busbar pair may supply power to a power conversion module.

In the power converter according to this application, the plurality of busbars included in the busbar group may be allocated to form a plurality of busbar pairs based on different power grid systems. Each busbar pair can supply power to one power conversion module. After a mode of connection to the power conversion module is selected, because the input power distribution connector may be connected to the input module in a plug-in manner, when a power supply voltage of a different system is connected, only an input module needs to be replaced with an input module that corresponds to the power supply voltage of the different system. It can be learned that, when the power connection assembly according to this application is used in a power conversion scenario, the power connection assembly is compatible with different input modules to switch between the power distribution systems. This is simple and easy to implement, and can reduce the development and maintenance costs of the devices.

Possibly, a signal terminal is further disposed on the input power distribution connector, and the signal terminal may be configured for communication, control, or another function based on a requirement. When the different power grid system is connected, the plurality of busbars in the busbar group may be implemented in different manners.

In a possible implementation, the busbar group includes at least two first busbars and at least two second busbars. Any second busbar and any first busbar form a busbar pair. This busbar group may be configured to be connected to a three-phase input power supply.

In a possible implementation, the busbar group includes at least two first busbars and at least two second busbars. Any first busbar and one second busbar form a busbar pair. This busbar group may be configured to be connected to a single-phase/dual-live wire/high-voltage direct current input power supply.

In a possible implementation, the busbar group includes at least two first busbars, at least two second busbars, and at least two third busbars. Any first busbar and any second busbar form a busbar pair, any second busbar and any third busbar form a busbar pair, and/or any first busbar and any third busbar form a busbar pair. This busbar group may be configured to be connected to a three-live wire input power supply.

According to a second aspect, this application provides an input unit. The input unit may include an input module, an input power distribution connector and a busbar group. The input power distribution connector has an input end and an output end. The input end of the input power distribution connector is plug-connected to the input module. When a different power grid system is connected, only an input module needs to be directly replaced with an input module that matches the power grid system. The busbar group includes a plurality of busbars. Each busbar includes an input end and an output end. The input end of each busbar is connected to the input power distribution connector. Any two busbars form a busbar pair. The busbar pair supplies power to a power conversion module. Based on different power supply requirements, the input module that matches the power grid system is plug-connected to the input power distribution connector. The busbars in the busbar group are allocated based on the different power grid systems to supply the power to the power conversion module. In this way, the input unit can adapt to the different power grid systems.

To improve security, the input module is connected to a surge protection assembly. The surge protection assembly may be specifically one or a combination of a voltage-dependent surge protector, a graphite gap surge protector, and a gas discharge surge protector.

When the different power grid system is connected, the input module and the busbar group may be implemented in different manners.

In a possible implementation, the busbar group includes three first busbars and at least one second busbar. The second busbar and any first busbar form a busbar pair. Correspondingly, the input module includes three first input blocks and one second input block. The three first input blocks are respectively connected to three live wires, and the second input block is connected to a neutral wire. The three first input blocks are respectively connected to input ends of the three first busbars by using the input power distribution connector. The three first input blocks one-to-one correspond to the input ends of the three first busbars. The second input block is connected to at least one second busbar by using the input power distribution connector.

In a possible implementation, the busbar group includes at least two first busbars and at least two second busbars. Any first busbar and any second busbar form a busbar pair. The input module includes a first input block and a second input block. The first input block and the second input block are separately connected to two input wires. The first input block is connected to an input end of each first busbar by using the input power distribution connector, and the second input block is connected to an input end of each second busbar by using the input power distribution connector.

In a possible implementation, the busbar group includes at least two first busbars, at least two second busbars, and at least two third busbars. Any first busbar and any second busbar form a busbar pair, any second busbar and any third busbar form a busbar pair, and/or any first busbar and any third busbar form a busbar pair. The input module includes a first input block, a second input block, and a third input block. The first input block, the second input block, and the third input block are respectively connected to live wires. The first input block is connected to an input end of each first busbar by using the input power distribution connector, the second input block is connected to an input end of each second busbar by using the input power distribution connector, and the third input block is connected to an input end of each third busbar by using the input power distribution connector.

The input module may further include an input assembly. The input end of the input power distribution connector is fastened to the input assembly which may be specifically a circuit board, a metal bar, or a conducting wire. Input wires of the input module may be electrically connected to the input end of the input power distribution connector by using the circuit board.

According to a third aspect, this application provides a power converter. The power converter may specifically include an output module, at least one power conversion module, and the input unit according to any one of the foregoing aspects. Each power conversion module has two input ends and at least one output end. The two input ends of each power conversion module are connected to two busbars in a busbar pair in a one-to-one correspondence. Output ends of all power conversion modules are connected to the output module.

Specifically, the input ends of the power conversion module are connected to the busbars by using a first connector. The output end of the power conversion module is connected to the output module by using a second connector. When the input ends and the output end of the power conversion module are located on a same side, the first connector and the second connector may be integrated to save space.

In a possible implementation, there may be a long distance between the input module and the second connector. The output module may be connected to the second connector by using a power distribution device. The power distribution device may be any one or a combination of a direct current busbar, a shunt, a contactor, a circuit breaker, and a fuse.

According to a fourth aspect, this application further provides a communication power supply. The communication power supply includes a housing and the power converter according to any one of the foregoing aspects. The power converter is accommodated in the housing, and the housing has a first avoidance opening that exposes the input unit and a second avoidance opening that exposes the output module.

### BRIEF DESCRIPTION OF DRAWINGS

FIG. 1a to FIG. 1c are schematic diagrams of power supply principles for different power grid systems in a conventional technology;
FIG. 2a and FIG. 2b are schematic diagrams of structures of a power connection assembly according to an embodiment of this application;
FIG. 3a is a schematic diagram of a structure of the power connection assembly in FIG. 2a connected to a three-phase input power supply;
FIG. 3b is a schematic diagram of a power supply principle of the power connection assembly in FIG. 3a connected to the three-phase input power supply;
FIG. 4a is a schematic diagram of a structure of the power connection assembly in FIG. 2a connected to a single-phase/dual-live wire/high-voltage direct current input power supply;
FIG. 4b is a schematic diagram of a power supply principle of the power connection assembly in FIG. 4a connected to the single-phase/dual-live wire/high-voltage direct current input power supply;
FIG. 5a is a schematic diagram of a structure of the power connection assembly in FIG. 2b connected to a three-phase input power supply;
FIG. 5b is a schematic diagram of a power supply principle of the power connection assembly in FIG. 5a connected to the three-phase input power supply;
FIG. 6a is a schematic diagram of a structure of the power connection assembly in FIG. 2b connected to a single-phase/dual-live wire/high-voltage direct current input power supply;
FIG. 6b is a schematic diagram of a power supply principle of the power connection assembly in FIG. 6a connected to the single-phase/dual-live wire/high-voltage direct current input power supply;
FIG. 7a is a schematic diagram of a structure of the power connection assembly in FIG. 2b connected to a three-live wire input power supply;
FIG. 7b is a schematic diagram of a power supply principle of the power connection assembly in FIG. 7a connected to the three-live wire input power supply;
FIG. 8a and FIG. 8b are schematic diagrams of structures of an input unit according to an embodiment of this application;
FIG. 9a is a schematic diagram of a structure of the input unit in FIG. 8b connected to a three-phase input power supply;
FIG. 9b is a schematic diagram of a power supply principle of the input unit in FIG. 9a connected to the three-phase input power supply;
FIG. 10a is a schematic diagram of a structure of the input unit in FIG. 8b connected to a single-phase/dual-live wire/high-voltage direct current input power supply;
FIG. 10b is a schematic diagram of a power supply principle of the input unit in FIG. 10a connected to the single-phase/dual-live wire/high-voltage direct current input power supply;
FIG. 11a is a schematic diagram of a structure of the input unit in FIG. 8b connected to a three-live wire input power supply;
FIG. 11b is a schematic diagram of a power supply principle of the input unit in FIG. 11a connected to the three-live wire input power supply;
FIG. 12 is an exploded view of a power converter according to an embodiment of this application;
FIG. 13 is a schematic connection diagram of partial structures in a power converter according to an embodiment of this application; and
FIG. 14 is a schematic diagram of a structure of a communication power supply according to an embodiment of this application.

### DESCRIPTION OF EMBODIMENTS

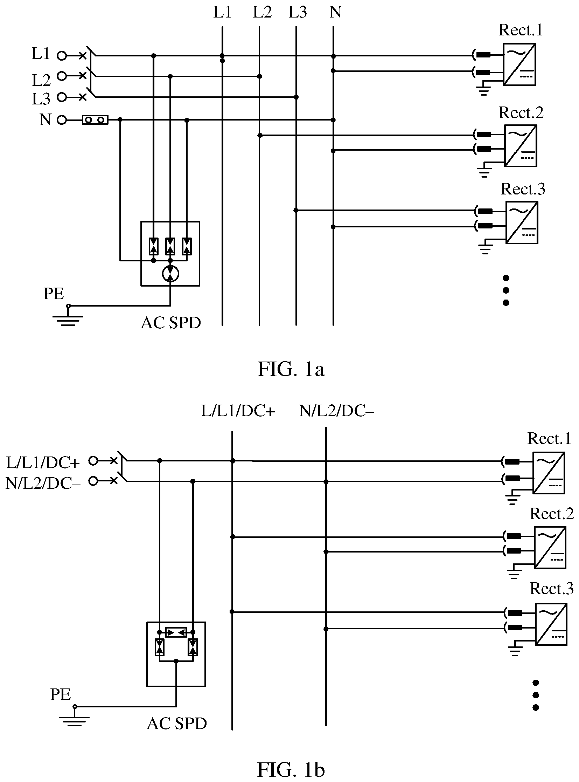

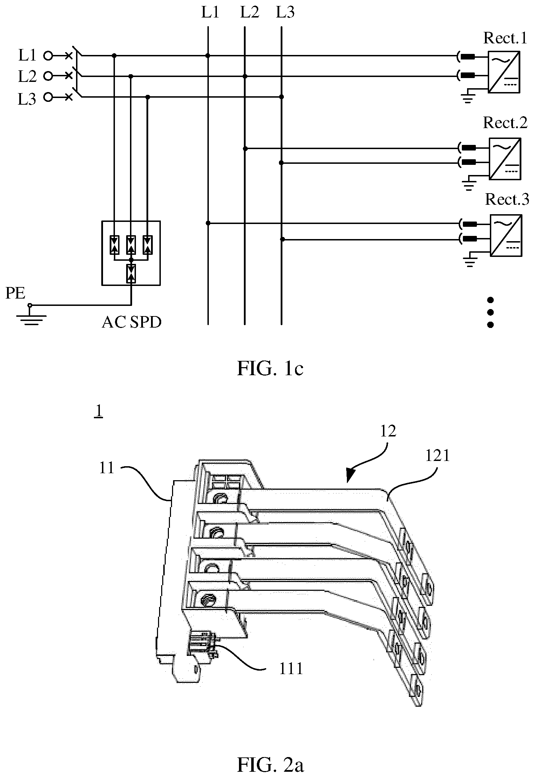

For common power grid systems in the conventional technology, refer to FIG. 1a to FIG. 1c. FIG. 1a shows a power supply principle for a three-phase input power supply. The three-phase input power supply has three live wires L1, L2, and L3, and one neutral wire N. A power conversion module (Rect) is correspondingly connected to one live wire (L1, L2, or L3) and the neutral wire (N). FIG. 1b shows a power supply principle for a single-phase/dual-live wire/high-voltage direct current input power supply. The single-phase/dual-live wire/high-voltage direct current input power supply has two input wires. The two input wires may be one live wire L and the neutral wire N, the two input wires may be the two live wires L1 and L2, or the two input wires may be two high-voltage direct current lines DC+ and DC-. One power conversion module is correspondingly connected to the two input wires. FIG. 1c shows a power supply principle for a three-live wire input power supply. The three-live wire input power supply includes three live wires L1, L2, and L3. One power conversion module is correspondingly connected to two of the live wires (L1 and L2, L2 and L3, or L1 and L3). An input end of the power grid system is further connected to an AC SPD (alternating current surge protection device, alternating current surge protection device). The AC SPD has a grounded PE conductor (protective earthing conductor, protective earthing conductor). Generally, to enable a communication power supply device to adapt to the foregoing different power grid systems, power conversion apparatuses of different architectures need to be developed. This greatly increases development and maintenance costs of devices. Currently, for structures that can adapt to the different power grid systems, most wiring structures are complex, and this causes poor user experience.

Based on this, embodiments of this application provide a power connection assembly, an input unit, a power converter having the input unit, and a communication power supply having the power converter, to resolve the foregoing problem. To make objectives, technical solutions, and advantages of this application clearer, the following further describes this application in detail with reference to the accompanying drawings.

Terms used in the following embodiments are merely intended to describe specific embodiments, but are not intended to limit this application. Terms "one", "a", "the", "the foregoing", "this", and "the one" of singular forms used in this specification and the appended claims of this application are also intended to include a form like "one or more", unless otherwise specified in the context clearly.

Reference to "one embodiment" or "some embodiments" described in this specification or the like means that one or more embodiments of this application include a particular feature, structure, or characteristic described in combination with the embodiment. Therefore, in this specification, statements, such as "in an embodiment", "in some embodiments", "in other embodiments", and "in some other embodiments" that appear at different places do not necessarily mean to refer to a same embodiment. Instead, the statements refer to "one or more but not all of embodiments", unless otherwise specifically emphasized. Terms "include", "contain", and "have", and their variants all mean "include but are not limited to", unless otherwise specifically emphasized.

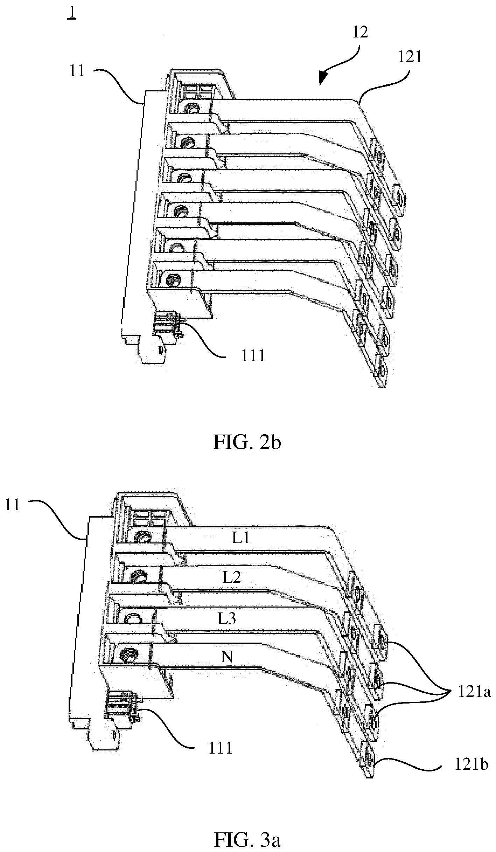

Refer to FIG. 2a and FIG. 2b. Embodiments of this application provide a power connection assembly 1. The power connection assembly 1 may be used for circuit connection of a power converter. The power connection assembly 1 specifically includes an input power distribution connector 11 and a busbar group 12. The input power distribution connector 11 has an input end and an output end. The input end of the input power distribution connector 11 is configured to be plug-connected to an input module, and the output end is configured to be connected to the busbar group 12. The busbar group 12 includes a plurality of busbars 121 (FIG. 2a shows four busbars 121, and FIG. 2b shows six busbars 121). Each busbar 121 also has an input end and an output end. The input end of each busbar 121 is configured to be connected to the output end of the input power distribution connector 11. Any two busbars 121 may form a busbar pair. The busbar pair may supply power to a power conversion module. A signal terminal 111 is further disposed on the input power distribution connector 11, and the signal terminal 111 may be configured for communication, control, or another function based on a requirement. Details are not described herein again.

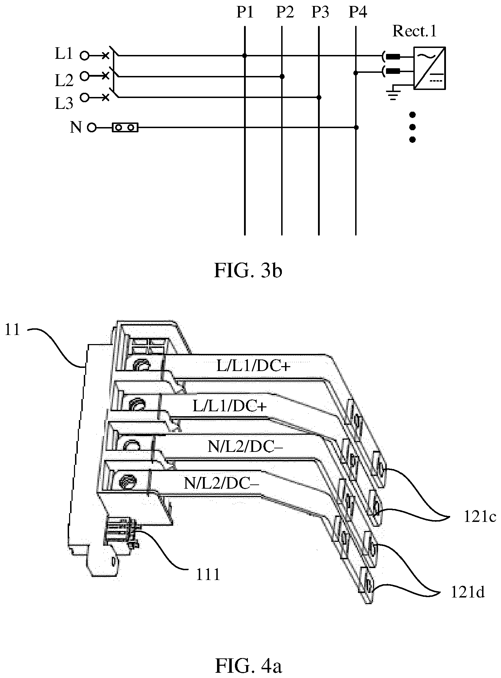

A structure of the power connection assembly 1 shown in FIG. 2a is used as an example. As shown in FIG. 3a, when the four busbars 121 are connected to a three-phase input power supply, the four busbars 121 may be connected to three live wires (L1, L2, and L3) and one neutral wire (N) in a one-to-one correspondence by using the input power distribution connector 11. It is set that the three busbars 121a are connected to the live wires, and one busbar 121b is connected to the neutral wire. When the power is supplied to the power conversion module, any busbar 121a connected to the live wire (L1, L2, or L3) and the busbar 121b connected to the neutral wire (N) may form a busbar pair, to supply power to a power conversion module. A circuit principle of the structure may be shown in FIG. 3b. FIG. 3b shows only one power conversion module. It should be understood that, any power conversion module needs to be connected to both one live wire and one neutral wire.

Refer to FIG. 3a and FIG. 3b. When the busbars 121 in the busbar group 12 of the power connection assembly 1 are connected to the three-phase input power supply, a defined mode of connection between each busbar 121 and a specific input wire can be adjusted based on a requirement (FIG. 3b is used as an example only). It is set that the four busbars 121 are P1, P2, P3, and P4 based on an arrangement sequence of actual items, that P4 is fastened to the neutral wire (N), and that P1 is fastened to the live wire (L1). Thus, connection modes in which the four busbars 121 are connected to the three-phase input power supply may be shown in the following Table 1.

**Table 1**

| Busbar | P1 | P2 | P3 | P4 |
|---|---|---|---|---|
| Mode 1 | L1 | L2 | L3 | N |
| Mode 2 | L1 | L3 | L2 | N |

It should be understood that, when the four busbars 121 in the busbar group 12 have a specified arrangement sequence, the connection modes shown in Table 1 in which the four busbars 121 are connected to the three-phase input power supply are implemented when one busbar 121a (P1) is fastened to the live wire (L1) and the busbar 121b (P4) is fastened to the neutral wire (N). If the connection modes in which the four busbars 121 are connected to the input wires are not specified, permutation and combination are performed on the connection modes in which the four busbars 121 are connected to the input wires of the three-phase input power supply, to obtain 24 connection modes in total. Examples are not provided herein one by one.

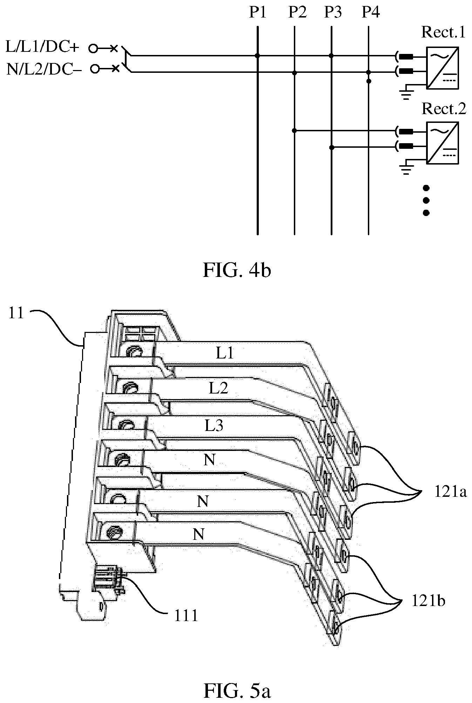

The structure of the power connection assembly 1 shown in FIG. 2a is used as an example. As shown in FIG. 4a, when the four busbars 121 are connected to a single-phase/dual-live wire/high-voltage direct current input power supply, each of two busbars 121c of the four busbars 121 may be connected to one input wire L/L1/DC+ by using the input power distribution connector 11, and each of the other two busbars 121d may be connected to another input wire N/L2/DC- by using the input power distribution connector 11. When the power is supplied to the power conversion module, any busbar 121c and any busbar 121d may form a busbar pair, to supply the power to the power conversion module. A circuit principle of the structure may be shown in FIG. 4b. FIG. 4b shows only two power conversion modules. It should be understood that, any power conversion module needs to be connected to two input wires.

Refer to FIG. 4a and FIG. 4b. When the busbars 121 in the busbar group 12 of the power connection assembly 1 are connected to the single-phase/dual-live wire/high-voltage direct current input power supply, a defined mode of connection between each busbar 121 and the input wire may alternatively be adjusted based on a requirement (FIG. 4b is used as an example only). It is set that the four busbars 121 are P1, P2, P3, and P4 based on an arrangement sequence of actual items. Thus, connection modes in which the four busbars 121 are connected to the single-phase/dual-live wire/high-voltage direct current input power supply may be shown in the following Table 2.

**Table 2**

| Busbar | P1 | P2 | P3 | P4 |
|---|---|---|---|---|
| Mode 1 | L/L1/DC+ | N/L2/DC- | L/L1/DC+ | N/L2/DC- |
| Mode 2 | L/L1/DC+ | L/L1/DC+ | N/L2/DC- | N/L2/DC- |
| Mode 3 | N/L2/DC- | L/L1/DC+ | L/L1/DC+ | N/L2/DC- |
| Mode 4 | N/L2/DC- | N/L2/DC- | L/L1/DC+ | L/L1/DC+ |
| Mode 5 | N/L2/DC- | L/L1/DC+ | N/L2/DC- | L/L1/DC+ |
| Mode 6 | L/L1/DC+ | N/L2/DC- | N/L2/DC- | L/L1/DC+ |

It should be understood that, when the four busbars 121 in the busbar group 12 have a specified arrangement sequence, there may be a total of six connection modes shown in Table 2 in which the four busbars 121 are connected to the single-phase/dual-live wire/high-voltage direct current input power supply.

Refer to FIG. 3a to FIG. 4b. The power connection assembly 1 shown in FIG. 2a according to this embodiment of this application may adapt to at least the three-phase input power supply and the single-phase/dual-live wire/high-voltage direct current input power supply. A connection mode for the power connection assembly 1 is simple, and this helps reduce development and maintenance costs of the power converter.

The structure of the power connection assembly 1 shown in FIG. 2b is used as an example. As shown in FIG. 5a, when six busbars 121 are connected to a three-phase input power supply, three busbars 121a may be connected to the three live wires (L1, L2, and L3) in a one-to-one correspondence by using the input power distribution connector 11, and the other three busbars 121b are respectively connected to neutral wires N by using the input power distribution connector 11. When the power is supplied to the power conversion module, any busbar 121a connected to the live wire and any busbar 121b connected to the neutral wire may form a busbar pair, to supply the power to the power conversion module. A circuit principle of the structure may be shown in FIG. 4b. FIG. 4b shows three power conversion modules. The three power conversion modules are connected to the three live wires in a one-to-one correspondence, to meet power supply balance of three-phase current inputs. Certainly, there may be other possibilities for a quantity and a connection mode of power conversion modules. A power supply requirement can be met provided that one power conversion module is connected to both one live wire and one neutral wire.

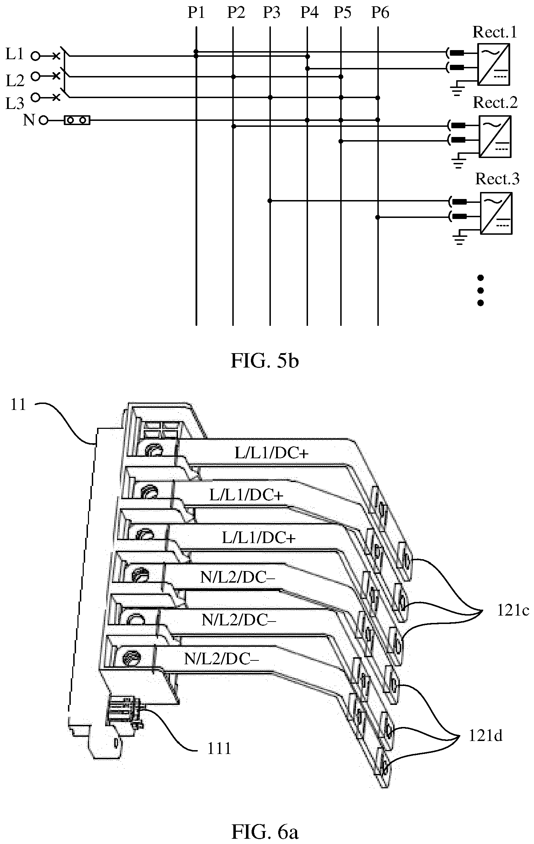

Refer to FIG. 5a and FIG. 5b. When the busbars 121 in the busbar group 12 of the power connection assembly 1 are connected to the three-phase input power supply, a defined mode of connection between each busbar 121 and a specific input wire can be adjusted based on a requirement (FIG. 5b is used as an example only). It is set that the six busbars 121 are P1, P2, P3, P4, P5, and P6 based on an arrangement sequence. P1, P2, and P3 are connected to the three live wires (L1, L2, and L3) in a one-to-one correspondence by using the input power distribution connector 11, and each of P4, P5, and P6 is connected to one neutral wire N by using the input power distribution connector 11. It is set that P1 is fastened to the live wire L1. Thus, connection modes in which the six busbars 121 are connected to the three-phase input power supply may be shown in Table 3.

**Table 3**

| Busbar | P1 | P2 | P3 | P4 | P5 | P6 |
|---|---|---|---|---|---|---|
| Mode 1 | L1 | L2 | L3 | N | N | N |
| Mode 2 | L1 | L3 | L2 | N | N | N |

It should be understood that, when the four busbars 121 in the busbar group 12 have a specified arrangement sequence, the connection modes shown in Table 3 in which the six busbars 121 are connected to the three-phase input power supply are implemented when one busbar 121a (P1) is fastened to the live wire (L1) and the three busbars 121b (P4, P5, and P6) are fastened to the neutral wires (N). If the connection modes in which the six busbars 121 are connected to the input wires are not specified, permutation and combination are performed on the connection modes in which the six busbars 121 are connected to the three-phase input power supply, to obtain 120 connection modes through calculation in total. Examples are not provided herein one by one.

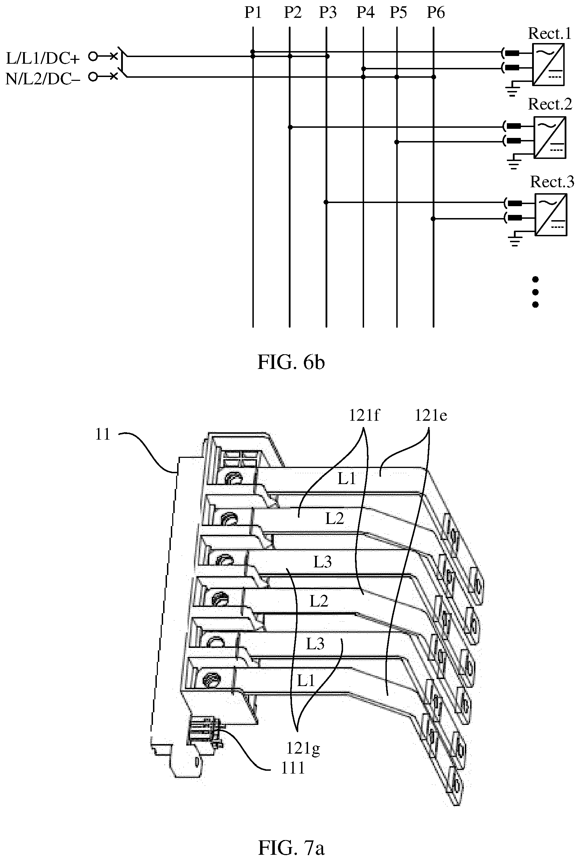

The structure of the power connection assembly 1 shown in FIG. 2b is used as an example. As shown in FIG. 6a, when the six busbars 121 are connected to a single-phase/dual-live wire/high-voltage direct current input power supply, each of three busbars 121c of the six busbars 121 may be connected to one input wire L/L1/DC+ by using the input power distribution connector 11, and each of the other three busbars 121d may be connected to another input wire N/L2/DC-by using the input power distribution connector 11. When the power is supplied to the power conversion module, any busbar 121c and any busbar 121d may form a busbar pair, to supply the power to the power conversion module. A circuit principle of the structure may be shown in FIG. 6b. FIG. 6b shows three power conversion modules. Each power conversion module needs to be connected to two input wires to meet the power supply requirement.

Refer to FIG. 6a and FIG. 6b. When the busbars 121 in the busbar group 12 of the power connection assembly 1 are connected to the single-phase/dual-live wire/high-voltage direct current input power supply, a defined mode of connection between each busbar 121 and the input wire may alternatively be adjusted based on a requirement (FIG. 6b is used as an example only). It is set that the six busbars 121 are P1, P2, P3, P4, P5, and P6 based on an arrangement sequence, that P5 is fastened to L/L1/DC+, and that P6 is fastened to N/L2/DC-. Thus, connection modes in which the six busbars 121 are connected to the single-phase/dual-live wire/high-voltage direct current input power supply may be shown in the following Table 4.

**Table 4**

| Busbar | P1 | P2 | P3 | P4 | P5 | P6 |
|---|---|---|---|---|---|---|
| Mode 1 | L/L1/DC+ | N/L2/DC- | L/L1/DC+ | N/L2/DC- | L/L1/DC+ | N/L2/DC |
| Mode 2 | L/L1/DC+ | L/L1/DC+ | N/L2/DC- | N/L2/DC- | L/L1/DC+ | N/L2/DC |
| Mode 3 | N/L2/DC- | L/L1/DC+ | L/L1/DC+ | N/L2/DC- | L/L1/DC+ | N/L2/DC- |
| Mode 4 | N/L2/DC- | N/L2/DC- | L/L1/DC+ | L/L1/DC+ | L/L1/DC+ | N/L2/DC- |
| Mode 5 | N/L2/DC- | L/L1/DC+ | N/L2/DC- | L/L1/DC+ | L/L1/DC+ | N/L2/DC- |
| Mode 6 | L/L1/DC+ | N/L2/DC- | N/L2/DC- | L/L1/DC+ | L/L1/DC+ | N/L2/DC- |

It should be understood that, when the six busbars 121 in the busbar group 12 have a specified arrangement sequence, the connection modes shown in Table 4 in which the six busbars 121 are connected to the single-phase/dual-live wire/high-voltage direct current input power supply are implemented when P5 is fastened to L/L1/DC+ and P6 is fastened to N/L2/DC-. If the connection modes in which the six busbars 121 are connected to the input wires are not specified, permutation and combination are performed on the connection modes in which the six busbars 121 are connected to the three-phase input power supply, to obtain 20 connection modes through calculation in total. Examples are not provided herein one by one.

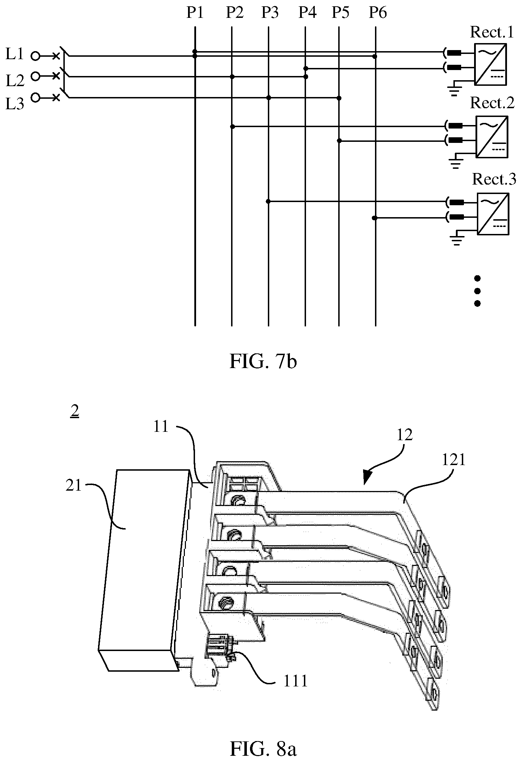

The structure of the power connection assembly 1 shown in FIG. 2b is used as an example. As shown in FIG. 7a, when the six busbars 121 are connected to a three-live wire input power supply, each of two busbars 121e of the six busbars 121 may be connected to a first live wire L1 by using the input power distribution connector 11, each of another two busbars 121f may be connected to a second live wire L2 by using the input power distribution connector 11, and each of still another two busbars 121g may be connected to a third live wire L3 by using the input power distribution connector 11. When the power is supplied to the power conversion module, two busbars 121 respectively connected to different live wires may form a busbar pair, to supply the power to the power conversion module. A circuit principle of the structure may be shown in FIG. 7b. FIG. 7b shows three power conversion modules. Each power conversion module needs to be connected to two live wires to meet the power supply requirement.

Refer to FIG. 7a and FIG. 7b. When the busbars 121 in the busbar group 12 of the power connection assembly 1 are connected to the three-live wire input power supply, a defined mode of connection between each busbar 121 and a specific input wire may alternatively be adjusted based on a requirement (FIG. 7b is used as an example only). It is set that the six busbars 121 are P1, P2, P3, P4, P5, and P6 based on an arrangement sequence of actual items, that P1 and P2 are fastened to one live wire (L1). Thus, connection modes in which the six busbars 121 are connected to the three-live wire input power supply may be shown in the following Table 5.

**Table 5**

| Busbar | P1 | P2 | P3 | P4 | P5 | P6 |
|---|---|---|---|---|---|---|
| Mode 1 | L1 | L1 | L2 | L2 | L3 | L3 |
| Mode 2 | L1 | L1 | L3 | L3 | L2 | L2 |
| Mode 3 | L1 | L1 | L2 | L3 | L3 | L2 |
| Mode 4 | L1 | L1 | L2 | L3 | L2 | L3 |
| Mode 5 | L1 | L1 | L3 | L2 | L2 | L3 |
| Mode 6 | L1 | L1 | L3 | L2 | L3 | L2 |

It should be understood that, when the six busbars 121 in the busbar group 12 have a specified arrangement sequence, the connection modes shown in Table 5 in which the six busbars 121 are connected to the single-phase/dual-live wire/high-voltage direct current input power supply are implemented when P1 and P2 are fastened to one live wire (L1). If the connection modes in which the six busbars 121 are connected to the input wires are not specified, permutation and combination are performed on the connection modes in which the six busbars 121 are connected to the three-phase input power supply, to obtain 20 connection modes through calculation in total. Examples are not provided herein one by one.

Refer to FIG. 5a to FIG. 7b. The structure having the power connection assembly 1 of the busbar group 12 shown in FIG. 2b can adapt to at least the three types of power supplies, that is, the three-phase input power supply, the single-phase/dual-live wire/high-voltage direct current input power supply, and the three-live wire input power supply. A connection mode for the power connection assembly 1 is simple, and this helps reduce the development and maintenance costs of the power converter.

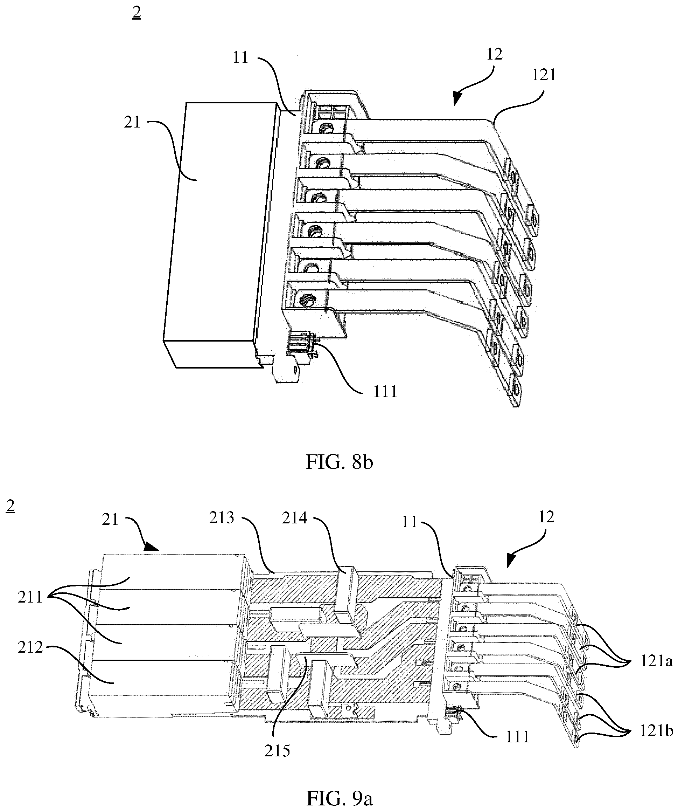

An embodiment of this application further provides an input unit 2 that may be used in a power converter. As shown in FIG. 8a and FIG. 8b, the input unit 2 may include an input module 21, the input power distribution connector 11, and the busbar group 12. The input power distribution connector 11 has the input end and the output end. The input end of the input power distribution connector 11 is plug-connected to the input module 21. When a power supply of a different power grid system is connected, an input module may be removed and replaced with a different input module 21. The busbar group 12 includes the plurality of busbars 121 (FIG. 8a shows four busbars 121, and FIG. 8b shows six busbars 121). Each busbar 121 also has the input end and the output end. The input end of each busbar 121 is configured to be connected to the output end of the input power distribution connector 11. Any two busbars 121 may form a busbar pair. The busbar pair may supply power to a power conversion module.

When the input module 21 is connected to a three-phase input power supply, a structure of the input unit 2 is shown in FIG. 9a. The input module 21 includes three first input blocks 211 and one second input block 212. The first input block 211 is connected to a live wire, and the second input block 212 is connected to a neutral wire. Correspondingly, the busbar group 12 may specifically include three first busbars 121a and at least one second busbar 121b (the following uses an example in which the busbar group 12 includes the six busbars 121, where there are three second busbars 121b). The second busbar 121b and any first busbar 121a form a busbar pair, to be connected to one power conversion module. The input module 21 further includes an input assembly of a structure such as a circuit board, a metal bar, and a conducting wire. The following shows a circuit board 213 as the input assembly. The input module 21 is connected to the input power distribution connector 11 in a pluggable manner by using the circuit board 213. The input end of the input power distribution connector 11 is fastened to the circuit board 213. Routing is performed on a surface of the circuit board 213 or inside the circuit board 213. The three first input blocks 211 and one second input block 212 are separately connected to the circuit board 213 in a pluggable manner. In this way, the three first input blocks 211 and one second input block 212 are in circuit connection to the input power distribution connector 11 by using the circuit board 213. The circuit board 213 herein implements interconnection between input and output through single-sided routing and in cooperation with a crossing bar 215. In FIG. 9a, to protect a circuit, the input module 21 may be further connected to a surge protection assembly 214. The surge protection assembly 214 may be one or a combination of a voltage-dependent surge protector, a graphite gap surge protector, and a gas discharge surge protector. The surge protection assembly 214 may be mounted in a fastened manner, or mounted on a board through soldering. In addition, the surge protection assembly 214 may be a separate surge protector combination, or may be an assembly integrated with a base. When the surge protection assembly 214 is integrated with the base, a proper base may be selected, to implement removal and replacement.

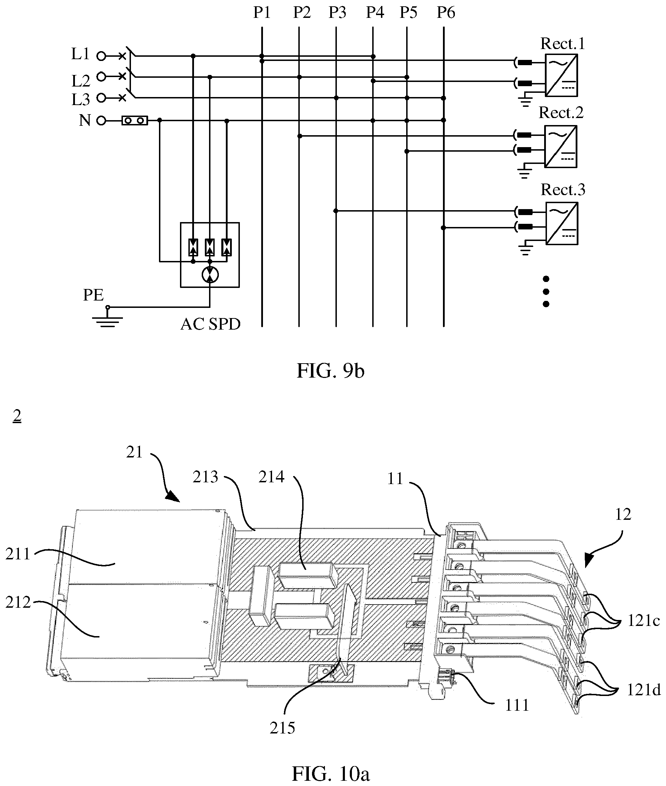

For a circuit connection principle of the input unit 2 shown in FIG. 9a, refer to FIG. 9b. An AC SPD, that is, the surge protection assembly 214, is grounded by using a PE. It is set that the six busbars 121 are P1, P2, P3, P4, P5, and P6 based on an arrangement sequence. P1, P2, and P3 are connected to the first input blocks 211 (L1, L2, and L3) in a one-to-one correspondence by using the input power distribution connector 11, and P4, P5, and P6 are connected to the second input block 212 (three Ns) in a one-to-one correspondence. Any one of P1, P2, and P3 and any one of P4, P5, and P6 may form a busbar pair, to be connected to one power conversion module. Each power conversion module is connected to both one live wire and one neutral wire to meet the power supply requirement.

When the input module 21 is connected to a single-phase/dual-live wire/high-voltage direct current input power supply, a structure of the input unit 2 is shown in FIG. 10a. The input module 21 includes the first input block 211 and the second input block 212. The first input block 211 is L/L1/DC+, and the second input block 212 is N/L2/DC-. Correspondingly, the busbar group 12 may specifically include at least two first busbars 121c and at least two second busbar 121d (the following uses an example in which the busbar group 12 includes the six busbars 121, where there are three first busbars 121c and three second busbars 121b). Any first busbar 121c and any second busbar 121d form a busbar pair, to be connected to one power conversion module. The input module 21 further includes the input assembly of the structure such as the circuit board, the metal bar, and the conducting wire. The circuit board 213 is shown as the input assembly. The input module 21 is connected to the input power distribution connector 11 in a pluggable manner by using the circuit board 213. The input end of the input power distribution connector 11 is fastened to the circuit board 213. Routing is performed on a surface of the circuit board 213 or inside the circuit board 213. The first input block 211 and the second input block 212 are separately connected to the circuit board 213 in a pluggable manner. In this way, the first input block 211 and the second input block 212 are in circuit connection to the input power distribution connector 11 by using the circuit board 213. The circuit board 213 herein implements the interconnection between the input and the output through the single-sided routing and in cooperation with the crossing bar 215. In FIG. 9a, to protect the circuit, the input module 21 may be further connected to the surge protection assembly 214. The surge protection assembly 214 may be one or a combination of a voltage-dependent surge protector, a graphite gap surge protector, and a gas discharge surge protector. The surge protection assembly 214 may be mounted in a fastened manner, or mounted on a board through soldering. In addition, the surge protection assembly 214 may be a separate surge protector combination, or may be an assembly integrated with a base. When the surge protection assembly 214 is integrated with the base, a proper base may be selected, to implement removal and replacement.

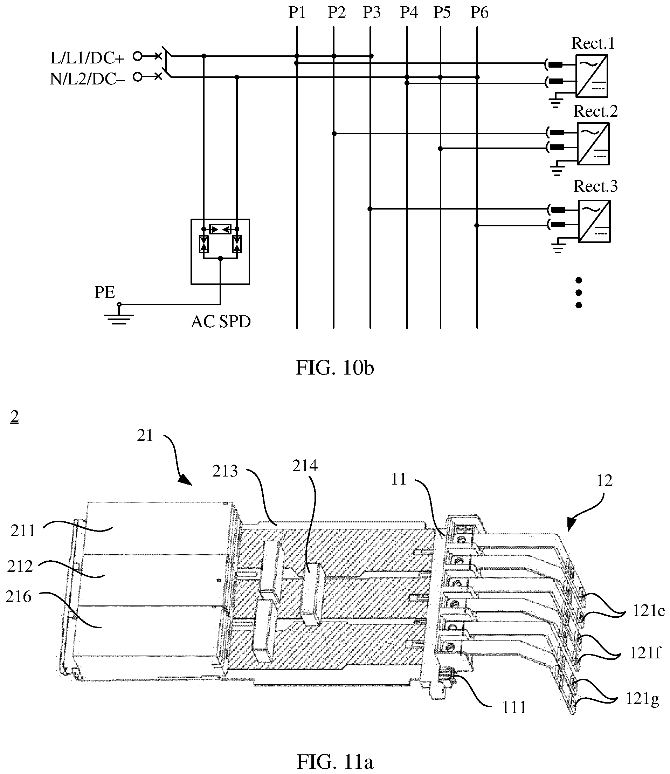

For a circuit connection principle of the input unit 2 shown in FIG. 10a, refer to FIG. 10b. An AC SPD, that is, the surge protection assembly 214, is grounded by using a PE. It is set that the six busbars 121 are P1, P2, P3, P4, P5, and P6 based on an arrangement sequence. P1, P2, and P3 are connected to the first input blocks 211 (L/L1/DC+) in a one-to-one correspondence by using the input power distribution connector 11, and P4, P5, and P6 are connected to the second input block 212 (N/L2/DC-) in a one-to-one correspondence. Any one of P1, P2, and P3 and any one of P4, P5, and P6 may form a busbar pair, to be connected to one power conversion module. Each power conversion module is connected to both one live wire and one neutral wire to meet the power supply requirement.

When the input module 21 is connected to a three-live wire input power supply, a structure of the input unit 2 is shown in FIG. 11a. The input module 21 includes the first input block 211, the second input block 212, and a third input block 216. The first input block 211, the second input block 212, and the third input block 216 are all connected to live wires. Correspondingly, the busbar group 12 may specifically include at least two first busbars 121e, at least two second busbars 121f, and at least two third busbars 121g (the following uses an example in which the busbar group 12 includes the six busbars 121, where there are two first busbars 121e, there are two second busbars 121f, and there are two third busbars 121g). Any first busbar 121e and any second busbar 121f form a busbar pair, any second busbar 121f and any third busbar 121g form a busbar pair, and/or any first busbar 121e and any third busbar 121g form a busbar pair. Each busbar pair may correspond to one power conversion module, in other words, each power conversion module needs to be connected to two live wires to meet the power supply requirement. The input module 21 further includes the input assembly of the structure such as the circuit board, the metal bar, and the conducting wire. The following shows the circuit board 213 as the input assembly. The input module 21 is connected to the input power distribution connector 11 in a pluggable manner by using the circuit board 213. The input end of the input power distribution connector 11 is fastened to the circuit board 213. Routing is performed on a surface of the circuit board 213 or inside the circuit board 213. The first input block 211 and the second input block 212 are separately connected to the circuit board 213 in a pluggable manner. In this way, the first input block 211 and the second input block 212 are in circuit connection to the input power distribution connector 11 by using the circuit board 213. The circuit board 213 herein implements the interconnection between the input and the output through the single-sided routing and in cooperation with the crossing bar 215. In FIG. 11a, to protect a circuit, the input module 21 may be further connected to the surge protection assembly 214. The surge protection assembly 214 may be one or a combination of a voltage-dependent surge protector, a graphite gap surge protector, and a gas discharge surge protector. The surge protection assembly 214 may be mounted in a fastened manner, or mounted on a board through soldering. In addition, the surge protection assembly 214 may be a separate surge protector combination, or may be an assembly integrated with a base. When the surge protection assembly 214 is integrated with the base, a proper base may be selected, to implement removal and replacement.

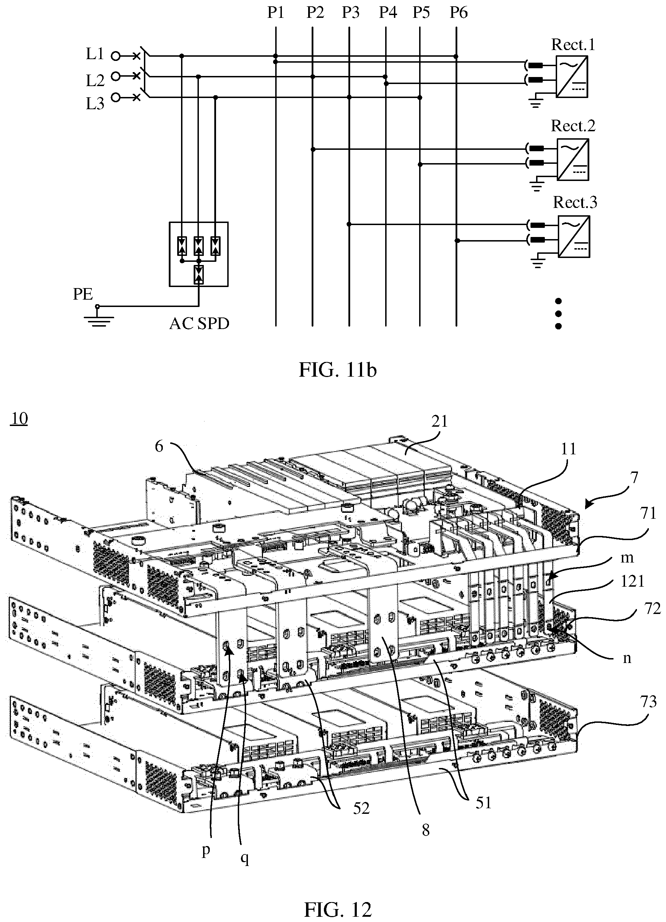

For a circuit connection principle of the input unit 2 shown in FIG. 11a, refer to FIG. 11b. An AC SPD, that is, the surge protection assembly 214, is grounded by using a PE. It is set that the six busbars 121 are P1, P2, P3, P4, P5, and P6 based on an arrangement sequence. P1 and P4 are separately connected to the first input block 211 (L1) by using the input power distribution connector 11. P2 and P5 are separately connected to the second input block 212 (L2) by using the input power distribution connector 11. P3 and P6 are separately connected to the third input block 216 (L3) by using the input power distribution connector 11. P1 or P4 may form a busbar pair with any one of P2, P3, P5, and P6. P2 or P5 may form a busbar pair with any one of P1, P3, P4, and P6. P3 or P6 may form a busbar pair with any one of P1, P2, P4, and P5.

It should be understood that, in actual application, for the input module 21, circuit components such as a circuit breaker, a fuse, a connector, a copper bar, and a wiring terminal may be flexibly configured based on different requirements. Details are not described herein again. In addition, refer to FIG. 9b, FIG. 10b, and FIG. 11b. In the input unit 2 according to this application, a connection relationship between each busbar 121 in the busbar group 12 and the power conversion module may be set as fastened engagement. In this setting, an electrical connection relationship between the busbar group 12 and the input module 21 may be changed based on a circuit connection requirement, so that the electrical connection relationship can adapt to different power grid systems.

It can be learned that in the input unit 2 according to this embodiment of this application, the input end of the input power distribution connector 11 is plug-connected to the input module 21. When a different power grid system is connected, only an input module needs to be directly replaced with the input module 21 that matches the power grid system. The busbar group 12 includes the plurality of busbars 121. Each busbar 121 includes the input end and the output end. The input end of each busbar 121 is connected to the input power distribution connector 11. Any two busbars 121 form a busbar pair. The busbar pair may supply the power to the power conversion module. In use, based on different power supply requirements, the input module 21 that matches the power grid system is plug-connected to the input power distribution connector 11. The busbars 121 in the busbar group 12 are allocated based on the different power grid systems to supply the power to the power conversion module. In this way, the input unit 2 can adapt to the different power grid systems.

Based on the input unit 2, an embodiment of this application further provides a power converter 10, specifically including an output module 6, at least one power conversion module 4, and the input unit 2 according to any one of the foregoing aspects. FIG. 12 is an exploded view of the power converter 10. The power converter 10 further has a frame 7 that supports the structure. Herein, the frame 7 has three support layers. The input module 21, the output module 6, and the input power distribution connector 11 are disposed on a first support layer 71 from top to bottom. In use, both the input module 21 and the output module 6 are configured to be connected to an external device, and are disposed adjacent to each other. This facilitates optimization of a spatial layout. Some of power conversion modules 4 are disposed on a second support layer 72, and the rest of the power conversion modules 4 are disposed on a third support layer 73. Herein, any power conversion module 4 has two input ends and at least one output end. The two input ends and all output ends are located on a same side, that is, a side facing the busbar group 12 in FIG. 12. First connectors 51 connected to the input ends of the power conversion modules 4 and second connectors 52 connected to the output ends of the power conversion modules 4 are disposed on both the second support layer 72 and the third support layer 73. The busbars 121 in the busbar group 12 extend from the first support layer 71 to the third support layer 73. The input end of each busbar 121 is connected to the output end of the input power distribution connector 11. The output end of each busbar 121 has a connection port m and a connection port n. The connection port m corresponds to the first connector 51 located on the second support layer 72, and is connected to the power conversion module 4 located on the second support layer 72. The connection port n corresponds to the first connector 51 located on the third support layer 73, and is connected to the power conversion module 4 located on the third support layer 73. The power conversion module 4 is connected to the output module 6 by using the second connector 52. Because the output module 6 is disposed on the first support layer 71, the output module 6 may alternatively be connected to the second connector 52 by using a power distribution device. The power distribution device may be specifically any one or a combination of a direct current busbar, a shunt, a contactor, a circuit breaker, and a fuse. Herein, an example in which the output module 6 is connected to the second connector 52 by using a direct current busbar 8 is used. A quantity of direct current busbars 8 is not limited. The second connectors 52 are disposed on both the second support layer 72 and the third support layer 73. Correspondingly, the direct current busbar 8 extends from the first support layer 71 to the third support layer 73. A connection port p and a connection port q are disposed on the direct current busbar 8. The connection port 1 corresponds to the second connector 52 located on the second support layer 72, and is connected to the power conversion module 4 located on the second support layer 72. The connection port q corresponds to the second connector 52 located on the third support layer 73, and is connected to the power conversion module 4 located on the third support layer 73.

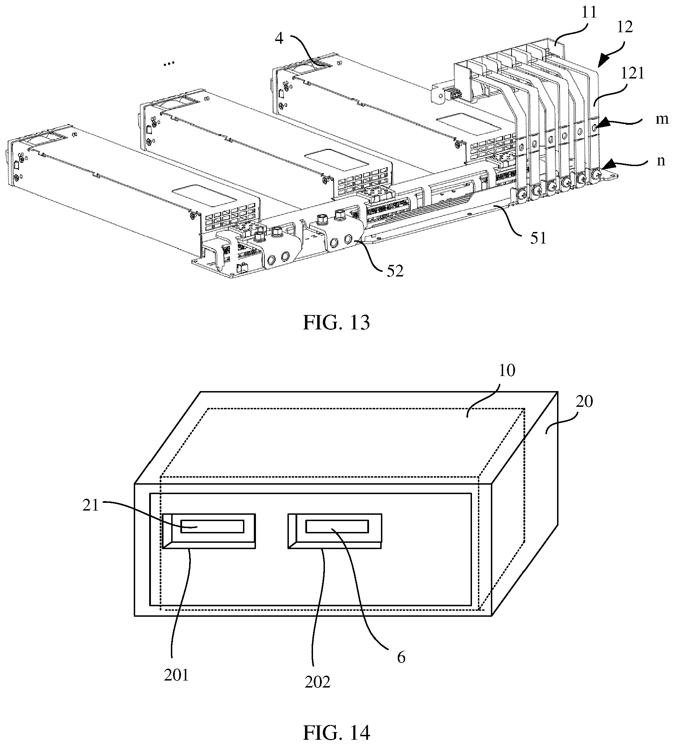

FIG. 13 shows a connection structure between the power conversion module 4 located on the third support layer 73 and the busbar group 12. The busbars 121 in the busbar group 12 are connected to the input ends of the power conversion module 4 by using the first connector 51. Herein, any power conversion module 4 has two input ends. The two input ends may correspond to two busbars 121 respectively (equivalent to a case in which one busbar group is correspondingly connected to one power conversion module 4). The output end of the power conversion module 4 may be connected to the output module 6 (not shown) by using the second connector 52. Based on a case in which the input ends and the output end of the power conversion module 4 are located on the same side, the first connector 51 and the second connector 52 may be combined as a whole to save space. This facilitates optimization of a module layout of the entire structure. It should be understood that the first connector 51 and the second connector 52 are only integrated in structure, and function implementations thereof are independent of each other. To be specific, communication of an electrical signal between the input ends of the power conversion module 4 and the busbar 121 is implemented by using the first connector 51, and communication of an electrical signal between the output end of the power conversion module 4 and the output module 6 is implemented by using the second connector 52.

It should be understood that the power converter 10 shown in FIG. 12 is merely a possible implementation. Because the power converter 10 includes a large quantity of power conversion modules 4, the entire structure is designed as a multi-layer structure. This facilitates a compact structure design and saves space. In actual application, a structure adjustment for adaptiveness may be performed based on an application scenario. In actual application, the output module 6 may be specifically a circuit component such as a connector and a card edge connector based on different requirements, to ensure that the output module 6 matches a connector in a power distribution system. In this way, the removal and replacement of a module is implemented. Details are not described herein.

In addition, it should be noted that, in a three-phase power supply scenario, live wires and a neutral wire that are connected to the power conversion module 4 are directional. In a single-phase power supply scenario, high-voltage direct current input DC+ and high-voltage direct current input DC- that are connected to the power conversion module 4 are also directional.

Based on the power converter 10, an embodiment of this application further provides a communication power supply. Certainly, the communication power supply may be another type of power supply. As shown in FIG. 14, the communication power supply includes a housing 20 and the power converter 10 according to any one of the foregoing aspects. The power converter 10 is disposed in the housing 20. The housing 20 may support and protect the power converter 10. The housing 20 has a first avoidance opening 201 that exposes the input module 21 and a second avoidance opening 202 that exposes the output module 6. A power grid may be connected to the input module 21 through the first avoidance opening 201, so that a current is input. After the current is converted by the power converter 10, the output module 6 may be connected to an external device through the second avoidance opening 201, to output a current that can be used by a user.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power connection assembly, comprising:
an input power distribution connector, wherein the input power distribution connector has an input end and an output end, and the input end of the input power distribution connector is configured to be plug-connected to an input module; and
a busbar group, wherein the busbar group comprises a plurality of busbars, each busbar has an input end and an output end, and the input end of each busbar is configured to be connected to the output end of the input power distribution connector, wherein
any two busbars form a busbar pair, and the busbar pair supplies power to a power conversion module.

2. The power connection assembly according to claim 1, wherein the busbar group comprises at least three first busbars and at least one second busbar; and
any second busbar and any first busbar form a busbar pair.

3. The power connection assembly according to claim 1, wherein the busbar group comprises at least two first busbars and at least two second busbars, wherein
any first busbar and any second busbar form a busbar pair.

4. The power connection assembly according to claim 1, wherein the busbar group comprises at least two first busbars, at least two second busbars, and at least two third busbars, wherein
any first busbar and any second busbar form a busbar pair;
any second busbar and any third busbar form a busbar pair; and/or
any first busbar and any third busbar form a busbar pair.

5. The power connection assembly according to any one of claims 1 to 4, wherein a signal terminal is disposed on the input power distribution connector.

6. An input unit, comprising an input module, an input power distribution connector, and a busbar group, wherein
the input power distribution connector has an input end and an output end, and the input end of the input power distribution connector is plug-connected to the input module; and
the busbar group comprises a plurality of busbars, each busbar has an input end and an output end, the input end of each busbar is connected to the input power distribution connector, any two busbars form a busbar pair, and the busbar pair supplies power to a power conversion module.

7. The input unit according to claim 6, wherein the busbar group comprises three first busbars and at least one second busbar, and the second busbar and any first busbar form a busbar pair;
the input module comprises three first input blocks and one second input block, the three first input blocks are respectively connected to three live wires, the second input block is connected to a neutral wire, the three first input blocks are respectively connected to input ends of the three first busbars by using the input power distribution connector, and the three first input blocks one-to-one correspond to the input ends of the three first busbars; and
the second input block is connected to at least one second busbar by using the input power distribution connector.

8. The input unit according to claim 6, wherein the busbar group comprises at least two first busbars and at least two second busbars, wherein any first busbar and any second busbar form a busbar pair; and
the input module comprises a first input block and a second input block, the first input block and the second input block are separately connected to two input wires, the first input block is connected to an input end of each first busbar by using the input power distribution connector, and the second input block is connected to an input end of each second busbar by using the input power distribution connector.

9. The input unit according to claim 6, wherein the busbar group comprises at least two first busbars, at least two second busbars, and at least two third busbars, wherein any first busbar and any second busbar form a busbar pair, any second busbar and any third busbar form a busbar pair, and/or any first busbar and any third busbar form a busbar pair; and
the input module comprises a first input block, a second input block, and a third input block, the first input block, the second input block, and the third input block are respectively connected to live wires, the first input block is connected to an input end of each first busbar by using the input power distribution connector, the second input block is connected to an input end of each second busbar by using the input power distribution connector, and the third input block is connected to an input end of each third busbar by using the input power distribution connector.

10. The input unit according to any one of claims 6 to 9, wherein the input module is connected to a surge protection assembly.

11. The input unit according to claim 10, wherein the surge protection assembly is one or a combination of a voltage-dependent surge protector, a graphite gap surge protector, and a gas discharge surge protector.

12. The input unit according to any one of claims 6 to 11, wherein the input module comprises an input assembly, and the input end of the input power distribution connector is fastened to the input assembly.

13. The input unit according to claim 12, wherein the input assembly is a circuit board, a metal bar, or a conducting wire.

14. A power converter, comprising an output module, at least one power conversion module, and the input unit according to any one of claims 6 to 13, wherein each power conversion module has two input ends and at least one output end; and
the two input ends of each power conversion module are connected to two busbars in the busbar pair in a one-to-one correspondence, and output ends of all power conversion modules are connected to the output module.

15. The power converter according to claim 14, wherein the input ends of the power conversion module are connected to the busbars by using a first connector, and the output end of the power conversion module is connected to the output module by using a second connector.

16. The power converter according to claim 15, wherein the output module is connected to the second connector by using a power distribution device.

17. The power converter according to claim 16, wherein the power distribution device is any one or a combination of a direct current busbar, a shunt, a contactor, a circuit breaker, and a fuse.

18. A communication power supply, comprising a housing and the power converter according to any one of claims 14 to 17, wherein the power converter is accommodated in the housing, and the housing has a first avoidance opening that exposes the input unit and a second avoidance opening that exposes the output module.
